Europäisches Patentamt

European Patent Office

Office européen des brevets

(11) Numéro de publication : **0 623 939 A1**

(19)

## (12) DEMANDE DE BREVET EUROPEEN

(21) Numéro de dépôt : **94400929.9**

(22) Date de dépôt : **29.04.94**

(51) Int. Cl.⁵ : **H01F 7/02, G01R 33/38**

(30) Priorité : **03.05.93 FR 9305239**

(43) Date de publication de la demande :
**09.11.94 Bulletin 94/45**

(84) Etats contractants désignés :
**DE IT NL**

(71) Demandeur : **COMMISSARIAT A L'ENERGIE
ATOMIQUE
31/33, rue de la Fédération
F-75015 Paris Cédex 15 (FR)**

(72) Inventeur : **Locatelli, Marcel
4, Pré Morard
F-38330 Montbonnot (FR)**
Inventeur : **Tournier, Edmond
2, Square Léon Martin
F-38000 Grenoble (FR)**

(74) Mandataire : **Signore, Robert et al
c/o BREVATOME
25, rue de Ponthieu
F-75008 Paris (FR)**

(54) **Structure d'aimant permanent pour la production d'une induction magnétique stable et homogène dans un volume donné.**

(57)    Structure d'aimant permanent pour la production d'une induction magnétique stable et homogène dans un volume donné, comportant un circuit magnétique formé d'une carcasse en matériau magnétique doux et de deux pôles N et S se terminant par des pièces polaires planes et parallèles délimitant entre elles le volume donné d'entrefer ouvert à l'extérieur et une association d'aimants en matériaux ferrite dur et en FeB(R) pour constituer la force magnéto-motrice de la structure, caractérisée en ce que les aimants des deux types précédents sont empilés en série, parallèlement aux pièces polaires entre celles-ci et la carcasse, leur induction ayant une direction perpendiculaire à ces mêmes pièces polaires.

FIG. 4

EP 0 623 939 A1

La présente invention se rapporte d'une manière générale aux aimants permanents qui permettent de produire une induction magnétique stable et homogène dans un volume donné et qui trouvent leurs applications industrielles, par exemple, dans l'imagerie par résonance magnétique.

L'imagerie par résonance magnétique (IRM) est une technique qui se répand très rapidement dans les milieux médicaux, ce qui a pour conséquence des exigences d'installation et d'exploitation de plus en plus contraignantes de la part des utilisateurs, notamment en ce qui concerne l'amplitude des inductions obtenues, leur homogénéité dans l'espace libre de l'entrefer où se trouve introduit le patient et, d'une manière générale, en ce qui concerne le poids des installations, les champs de fuite des aimants et les problèmes de maintenance et d'investissement.

Les techniques connues de réalisation d'aimants permanents de ce genre consistent toujours à insérer dans un circuit magnétique des aimants proprement dits qui constituent les forces magnétomotrices du système et créent l'induction. On considère ici les configurations d'aimants permanents comportant au moins une carcasse magnétique en matériau doux, deux pôles ou pièces polaires opposés, l'un Nord et l'autre Sud, qui délimitent entre eux la zone utile de l'entrefer et, à des endroits variables du circuit magnétique précédent, des aimants permanents qui en constituent des forces magnétomotrices. En imagerie par résonance magnétique, le circuit magnétique de l'aimant comporte en général deux plaques en vis-à-vis qui constituent les pièces polaires des deux pôles Nord et Sud et qui délimitent la cavité dans laquelle sont introduits les matériaux ou les êtres vivants que l'on désire soumettre à une induction magnétique donnée. Cet espace libre dans l'entrefer comporte en général également un volume d'accès proprement dit et au centre de la structure un volume utile à l'intérieur duquel l'induction magnétique est suffisamment homogène pour les besoins de l'expérimentation envisagée.

L'imagerie à résonance magnétique nucléaire nécessite la production d'une induction qui est généralement de l'ordre de 0,1 Tesla à 2 Tesla et dont l'homogénéité doit être supérieure à $10^{-4}$ dans un volume accessible qui peut être une sphère d'un diamètre de l'ordre de 400 mm.

Pour produire de telles inductions, on recourt plutôt dans l'appareillage médical à des aimants permanents dont l'exploitation est beaucoup plus économique que celle des électroaimants qui sont ou bien consommateurs d'énergie électrique dans le cas de systèmes à bobines résistives ou consommateurs de fluide cryogénique dans le cas de système à bobines supraconductrices. Parmi ces aimants permanents, il en existe essentiellement de deux sortes utilisés couramment qui sont les aimants en ferrite dur et les aimants en terre rare dont le matériau magnétique est du type FeBR, formule dans laquelle B représente l'atome de bore et R représente une terre rare. Cette dernière est d'ailleurs souvent du néodyme Nd.

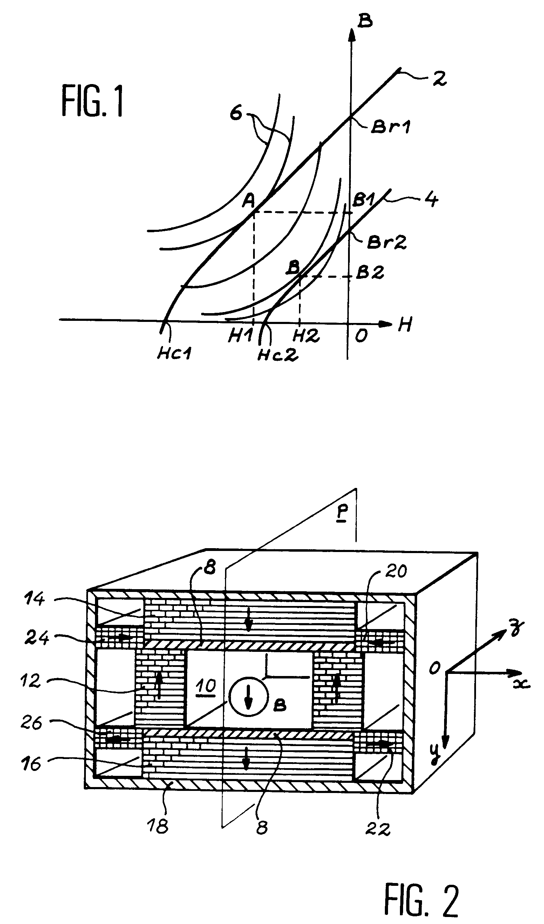

L'un des problèmes importants que résout la présente invention, est la recherche de l'optimum pour l'efficacité de la structure d'aimant permanent, c'est-à-dire l'obtention de l'induction la plus élevée avec le poids le plus faible de matériau magnétique et ceci, aux moindres frais, dans un espace aussi grand que possible. Or, la théorie permet de déterminer pour un aimant donné les valeurs du champ et de l'induction qui permettent d'optimiser son fonctionnement sous l'angle des grandeurs rappelées précédemment. A ce sujet, le lecteur voudra bien se reporter à la figure 1 qui montre en coordonnées cartésiennes dans le plan B, H, les parties inférieures des courbes d'aimantation 2 (pour un aimant du type FeBR) et 4 (pour un aimant en ferrite). Pour la valeur zéro du champ, l'induction de l'aimant en ferrite a la valeur rémanente $B_{r1}$ et l'aimant en ferrite a l'induction rémanente de valeur $B_{r2}$. Pour les valeurs nulles de l'induction les deux champs coercitifs des matériaux FeBR et ferrite dur sont respectivement notés sur le schéma $H_{c1}$ et $H_{c2}$. On a encore représenté sur ce schéma le faisceau des courbes d'isoénergie 6 qui représentent le produit BxH. Pour chaque matériau constitutif des aimants, on détermine le point optimal de fonctionnement ($B_{opt}$, $H_{opt}$). Ce point est le point de tangence de la courbe de désaimantation relative au matériau et la courbe d'isoénergie la plus élevée possible (E=BxH).

La théorie connue, qu'il n'y a pas lieu de rappeler ici, enseigne que c'est aux point où la courbe de désaimantation 2 ou 4 est tangente aux courbes d'isoénergie, c'est-à-dire au point A pour l'aimant FeBR et au point B pour l'aimant en ferrite, que l'aimant a son rendement optimal. Ce sont donc idéalement les points de fonctionnement marqués A et B sur le dessin qu'il faut rechercher à obtenir dans les constructions de structures d'aimants permanents.

De nombreuses configurations de structures à aimants permanents ont été imaginées jusqu'à ce jour sur la base des données théoriques qui précèdent. Elles possèdent toutes des avantages et des inconvénients et les progrès techniques de l'une à l'autre, dans l'ordre de leur apparition dans le temps, sont souvent malheureusement très minimes.

Une solution comprise dans l'état de la technique mais non encore publiée est décrite dans la demande de brevet français EN 93 02700 du 9 Mars 1993 au nom du demandeur pour "Structure d'aimant permanent à haute efficacité et à faibles fuites". La technique décrite dans cette demande est représentée ici dans son mode de réalisation le plus élaboré sur la figure 2. Elle utilise en particulier du ferrite dur comme aimant permanent et elle a été proposée pour produire des inductions jusqu'à 0,2 Tesla avec une efficacité optimale pour les aimants permanents. La configuration générale de cette structure antérieure comprend deux pièces polaires 8 en matériau magnétique doux qui forment les deux faces horizontales d'un tunnel 10 dans lequel s'exerce l'induction magnétique recherchée. Les deux autres faces du tunnel 10, qui a la forme d'un parallélépipède, sont occupées par des aimants permanents 12 de polarisation verticale et de même sens, formant une structure élémentaire connue sous le nom de structure de Watson. Sur les faces horizontales externes opposées des pièces polaires 8 sont disposés des aimants permanents 14 et 16 de même nature, de polarisation verticale et de même sens, mais opposé à celle de l'aimant permanent 12 de la structure de Watson. Ces aimants font partie d'une structure élémentaire connue sous le nom de structure en H complétée par une carcasse en matériau magnétique doux 18. La structure est également complétée par quatre aimants permanents 20, 22, 24, 26 de même nature disposés entre les pièces polaires 8 et la carcasse 18, mais cette fois de polarisation horizontale et de sens opposés deux à deux, de façon compatible avec l'induction B dans l'entrefer 10 en forme de tunnel.

A l'aide de la structure connue de la figure 2, l'induction se trouve néanmoins limitée à une valeur de 0,2 Tesla du fait des caractéristiques magnétiques propres aux ferrites durs. Une autre structure décrite dans le brevet japonais 61034242 utilise des aimants permanents du type FeBR, le radical R pouvant être du néodyme, afin d'augmenter l'induction qui peut alors dépasser le plafond de 0,2 Tesla. Cette technique, bien qu'intéressante, présente le désavantage d'utiliser un matériau très coûteux, ce qui a conduit l'homme de métier à rechercher toujours d'autres perfectionnements.

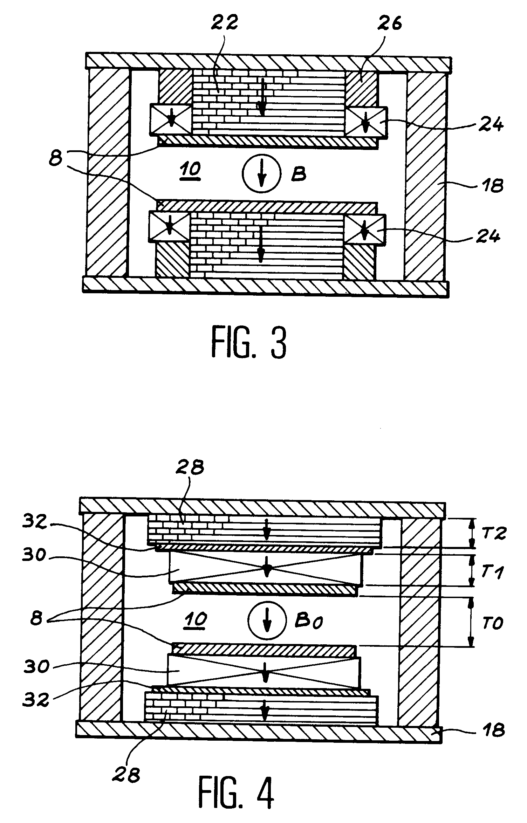

Une autre solution également connue et décrite dans le brevet européen 0 262 880 au nom de SUMITOMO, consiste à associer en parallèle dans le cas d'une structure du type H les deux types d'aimant permanent en ferrite et en FeBR. Dans cette solution connue qui est décrite sur la figure 3 on retrouve les pièces polaires 8 et la carcasse 18 mais les aimants utilisés comportent en parallèle un premier aimant permanent en ferrite 22 et un second aimant permanent en FeBR 24. Les deux aimants précédents sont adaptés pour optimiser l'efficacité, ce qui conduit en particulier à une épaisseur plus faible des aimants 24 en terre rare et à combler la différence de hauteur entre l'aimant 22 et l'aimant 24 par une pièce en matériau doux 26. Cette structure représente théoriquement un progrès sur la précédente mais du fait que les deux aimants de nature différente sont placés côte à côte en parallèle, le matériau doux 26 provoque un court-circuit partiel des aimants en ferrite 24 d'où malgré tout une perte d'efficacité.

La présente invention a pour objet une structure d'aimant permanent pour produire une induction magnétique stable et homogène dans un volume donné qui permet de perfectionner encore la technique précédente d'une manière particulièrement simple.

Cette structure d'aimant permanent comportant un circuit magnétique formé d'une carcasse en matériau magnétique doux, de deux pôles N et S se terminant par des pièces polaires planes et parallèles délimitant entre elles le volume donné d'entrefer ouvert à l'extérieur, et une association d'aimants en matériaux ferrite dur et en FeB(R) pour constituer la force magnétomotrice, se caractérise en ce que les aimants des deux types précédents sont empilés en série, parallèlement aux pièces polaires entre celles-ci et la carcasse, leur induction ayant une direction perpendiculaire à ces mêmes pièces polaires.

Comme on le verra plus loin, cette structure où les deux espèces d'aimants permanents les plus couramment utilisés dans cette technique sont en série et non plus en parallèle permet de choisir leur point de fonctionnement de façon que ces mêmes matériaux travaillent avec les valeurs optimales du champ et de l'induction. (Voir points A et B de la figure 1). Ces valeurs dépendent bien sûr du matériau et elles correspondent au point de tangence entre la courbe de désaimantation de chacun d'entre eux et les courbes d'isoénergie de la figure 1 pour le ferrite et pour le FeBNd par exemple. La pente des droites de désaimantation est directement liée aux dimensions géométriques de ces mêmes aimants permanents. C'est la nature, la forme et la répartition des aimants ainsi que les dimensions et la forme des pièces polaires et de la carcasse qui permettent d'obtenir dans chaque cas particulier une structure qui fonctionne magnétiquement à son point d'efficacité maximale.

Selon la caractéristique essentielle du mode de réalisation préféré de l'invention, les aimants sont au nombre de deux dans chaque pôle, séparés par une pièce polaire secondaire de forme plane, à savoir :
- un aimant en ferrite entre la carcasse magnétique et la pièce polaire secondaire,
- un aimant en terre rare entre les deux pièces polaires,

la section offerte au flux magnétique par les aimants étant plus grande pour l'aimant en ferrite que pour l'aimant en terre rare, dans un rapport sensiblement inversement proportionnel à leurs inductions.

La pièce polaire de forme plane placée entre l'aimant en ferrite et l'aimant en terre rare a pour but d'assurer la continuité de la circulation du flux magnétique entre ces deux mêmes aimants. Par ailleurs, en première approximation, on peut considérer que les flux magnétiques dans les deux types de matériaux sont identiques ce qui conduit, du fait que l'induction dans l'aimant en terre rare est supérieure à celle de l'aimant en ferrite, a donner à l'aimant en ferrite une section normale au flux supérieure à la section de l'aimant en terre rare. L'aimant en ferrite et la pièce polaire secondaire de forme plane qui le recouvre sont donc plus larges que l'aimant en terre rare associé, la pièce polaire secondaire de forme plane en matériau magnétique doux jouant alors également un rôle de canalisation du flux aux extrémités de l'aimant en ferrite de façon à minimiser les fuites qui pourraient se produire à cet endroit en les canalisant vers l'aimant en terre rare.

Bien entendu on ne sort pas du cadre de l'invention en donnant aux aimants, aux pièces polaires et à la carcasse, dès lors que les conditions précédemment énoncées sont remplies, des formes géométriques variées, telles que notamment des sections droites par des plans perpendiculaires à la direction de l'induction dans le volume dans l'entrefer de forme rectangulaire, carrée ou circulaire.

C'est ainsi que, selon une caractéristique de l'invention, lorsque les sections des aimants et des pièces polaires par des plans perpendiculaires à la direction de l'induction dans le volume de l'entrefer ont une forme géométrique choisie parmi les rectangles, les carrés et les cercles, la carcasse est alors composée d'un cylindre de matériau doux à base de forme choisie de façon correspondante selon les rectangles, les carrés et les cercles, dans lequel est ménagée l'ouverture nécessaire de l'entrefer vers l'extérieur de la carcasse.

Selon un premier mode de mise en oeuvre perfectionné de l'invention, la partie périphérique du volume d'entrefer est rempli entre les pièces polaires, par des premiers aimants permanents en ferrite dur, d'aimantation parallèle et de sens opposé à celle des aimants de la structure.

Selon un second mode de mise en oeuvre perfectionné de la présente invention, des seconds aimants permanents en ferrite dur, d'aimantation perpendiculaire à la direction de l'induction dans le volume utile de l'entrefer, sont situés entre les bords des pièces polaires secondaires et la paroi en regard de la carcasse, ces aimants permanents ayant, par rapport au centre de la structure, une aimantation convergente pour les aimants reliés à l'une des pièces polaires secondaires et une aimantation divergente pour les aimants reliés à l'autre des pièces polaires secondaires, le sens de ces aimantations étant choisi compatible avec celui des aimants des pôles N et S pour augmenter le flux dans l'entrefer.

Selon un troisième mode de mise en oeuvre perfectionné de l'invention, des troisièmes aimants en ferrite dur d'aimantation perpendiculaire à la direction de l'induction dans le volume utile de l'entrefer, sont situés entre la périphérie des pièces polaires et la paroi en regard de la carcasse, ces aimants ayant, par rapport au centre de la structure, une aimantation convergente pour les aimants reliés à l'une des pièces polaires et une aimantation divergente pour les aimants reliés à l'autre pièce polaire, le sens de ces aimants étant choisi compatible avec celui des aimants N et S pour augmenter le flux dans l'entrefer.

En d'autres termes, la structure de base de l'invention qui comporte une carcasse, deux pôles doubles forces magnétomotrices constituées par un empilement en série de deux aimants de nature différente peut être complètée à volonté par des forces magnétomotrices auxiliaires qui viennent renforcer l'induction dans l'entrefer et qui se composent isolément ou en combinaison de premiers, de seconds ou de troisièmes aimants. Le plus souvent bien entendu, les structures réalisées auront avantage à combiner deux au moins de ces familles d'aimants auxiliaires complémentaires mais il est bien entendu qu'on ne sort pas du cadre de la présente invention en utilisant les uns ou les autres de ces aimants complémentaires seuls ou dans leurs diverses combinaisons entre eux. On citera notamment comme envisageable, mais de façon non restrictive :

- le cas où les sections des aimants et les pièces polaires par des plans perpendiculaires à la direction de l'induction dans le volume de l'entrefer étant carrées ou rectangulaires, les premiers aimants permanents en ferrite dur sont de forme parallèlépipédique, formant ainsi avec les pièces polaires un volume utile d'entrefer en forme de tunnel ;
- le cas où les sections des aimants et des pièces polaires par des plans perpendiculaires à la direction de l'induction dans le volume de l'entrefer étant circulaires, les premiers aimants permanents en ferrite dur sont de forme torique à section rectangulaire, formant ainsi avec les pièces polaires un volume utile d'entrefer en forme de cylindre droit à base circulaire muni d'une fenêtre d'accès vers l'extérieur ;
- le cas où les seconds aimants permanents sont disposés sur une partie seulement de la périphérie des pièces polaires secondaires ;
- le cas où les seconds aimants permanents sont disposés sur toute la périphérie des pièces polaires secondaires ;
- le cas où les troisièmes aimants permanents sont disposés sur une partie seulement de la périphérie des pièces polaires ;
- le cas où les troisièmes aimants permanents sont disposés sur toute la périphérie des pièces polaires.

De toute façon, l'invention sera mieux comprise en se référant à la description de plusieurs exemples de mise en oeuvre qui seront décrits à titre explicatif et non limitatif en se référant aux figures 4, 5 et 6 ci-jointes sur lesquelles :

- la figure 4 représente la structure de base de l'invention réduite à sa plus simple expression ;
- la figure 5 représente un mode de mise en oeuvre de l'invention dans lequel la structure de base précédente est équipée de premiers et de deuxièmes aimants complémentaires ;
- la figure 6 représente un mode de mise en oeuvre de l'invention dans lequel la structure de base est complétée par des premiers, des seconds et des troisièmes aimants complémentaires.

Sur la figure 4, on a représenté l'invention dans sa forme la plus générale. La structure d'aimant permanent comporte, conformément à l'invention, les pièces polaires 8, la carcasse 18, l'entrefer 10 et les deux pôles Nord et Sud constitués chacun d'un aimant en ferrite 28 et d'un aimant en terre rare 30 situés en série l'un sur l'autre et séparés par les pièces polaires secondaires 32. Sur la figure 4 les flèches indiquent le sens des inductions dans les différentes parties de la structure.

On peut sur cette structure comprendre la façon dont sont optimisés les dimensions et grandeurs physiques des aimants et de l'entrefer pour parvenir au fonctionnement le meilleur. Dans la suite de cet exposé, on désignera par $H_0$, $B_0$, le champ et l'induction dans l'entrefer 10 ; par $H_1$ et $B_1$ le champ et l'induction dans l'aimant en terre rare 30 et $H_2$ et $B_2$ le champ et l'induction dans l'aimant en ferrite 28. Les surfaces des sections droites des pièces polaires 8 ont la valeur $S_0$ ; les sections droites de l'aimant en terre rare 30 ont la valeur $S_1$ et les sections droites de l'aimant en ferrite 28 ont la valeur $S_2$. On désignera également par $T_0$ la hauteur de la cavité utile de l'entrefer 10 ; par $T_1$ l'épaisseur de l'aimant en terre rare 30 et par $T_2$ l'épaisseur de l'aimant en ferrite 28.

Si l'on néglige la circulation du vecteur champ dans la carcasse magnétique 18 ce qui est une approximation classique acceptable, le champ magnétique H et l'induction B sont liés aux dimensions de la structure et à l'induction utile $B_0$ dans l'entrefer par les relations suivantes :

- la conservation du flux dans sa circulation dans les aimants et dans l'entrefer permet d'écrire $B_0 S_1 = B_1 S_1 = B_2 S_2$ ;
- la circulation du vecteur champ dans le système permet d'écrire $H_0 T_0 = H_1 T_1 + H_2 T_2$.

De la première équation précédente on déduit que $B_1 = B_0$.

Par ailleurs, les matériaux en terre rare type FeBNd présentent une activité optimale pour des inductions voisines de 0,3 Tesla et un champ démagnétisant de l'ordre de 400.000 Amp/m. Pour le matériau ferrite dur, cette valeur optimale se situe au voisinage de 0,2 Tesla pour l'induction et de 160.000 Amp/m pour le champ démagnétisant. Il en résulte que $S_2/S_1 = B_1/B_2 = 0,3/0,2$ Tesla = 1,5. Le champ $H_0$ dans l'entrefer étant égal à 240.000 Amp/m pour une induction de 0,3 Tesla, on peut donc écrire l'équation :

$$T_0 \times 240.000 = T_1 \times 400.000 + TR \times 160.000 \text{ avec}$$
$$H_0 = 240.000.$$

Si donc, l'espace utile minimal nécessaire pour loger par exemple un être humain dans l'entrefer 10 a une valeur $T_0$ donnée, l'équation précédente donne une relation linéaire entre $T_1$ et $T_2$ qu'il faut satisfaire et que l'on résoud dans chaque cas particulier à l'aide des critères tels que le coût de la structure et sa masse. Comme on l'a déjà indiqué dans ce qui précède, la structure de base de l'invention décrite sur la figure 4 est susceptible d'être complétée à volonté par toute combinaison d'aimants complémentaires de trois sortes différentes.

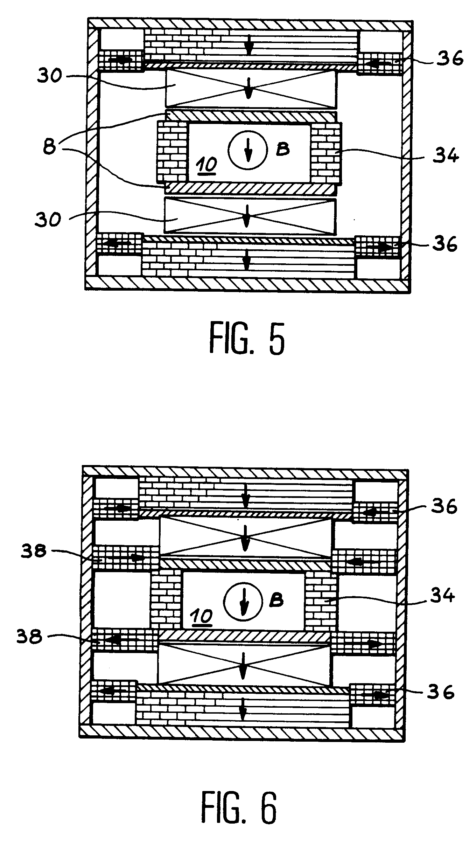

Sur la figure 5 on a représenté la structure de la figure 4 complétée par des premiers aimants auxiliaires 34 et des seconds aimants auxiliaires 36 les autres composantes de la structure portant les mêmes nombres de référence que sur la figure 4 et jouant le même rôle. Comme sur la figure 4 précédente, on a représenté par des flèches le sens des inductions qui permet de voir que les deuxièmes aimants complémentaires 36 ont des inductions convergentes par rapport à l'axe de symétrie de la structure, mais de sens opposés l'une à l'autre. Dans le mode de réalisation de la figure 5, les premiers et deuxièmes aimants 34 et 36 peuvent être selon la forme des autres pièces de la structure, parallélépipédiques ou toriques annulaires. Ils peuvent également être situés sur tout le pourtour des pièces polaires secondaires 32 ou sur une partie seulement de ce pourtour selon les résultats particuliers recherchés par l'homme du métier.

Sur la figure 6, on montre enfin une structure complète conforme à l'invention qui associe à la structure de base de la figure 4, les premiers aimants 34, les seconds aimants 36 et les troisièmes aimants 38. Comme précédemment, on voit les premiers aimants constitués entre les pièces polaires principales, les deuxièmes aimants entre les pièces polaires secondaires et la carcasse et les troisièmes aimants entre les pièces polaires principales et la carcasse. Les troisièmes aimants 38 sont comme les deuxièmes aimants 36 prévus avec une induction convergente vers l'axe du système et un sens opposé de l'un à l'autre.

Bien entendu dans le cadre de la figure 6, l'homme du métier saura choisir le sens des inductions des aimants auxiliaires dénommés précédemment premiers, deuxièmes et troisièmes aimants de façon à ce qu'ils collaborent de manière positive à l'augmentation du flux dans l'entrefer.

A titre d'exemple de mise en oeuvre de l'invention, on a obtenu dans le volume utile de l'entrefer 10 des structures précédemment décrites, des inductions de 0,3 Tesla avec les quantités de matériaux suivantes :

- pour le FeBNd : 1,7 T ;
- pour le ferrite dur : 0,4 T ;
- pour le matériau doux : 6 T ;

soit un total de 16,1 T.

Ce résultat est tout à fait satisfaisant si on le compare à ceux de l'art antérieur connu.

## Revendications

1. Structure d'aimant permanent pour la production d'une induction magnétique stable et homogène dans un volume donné, un circuit magnétique formé d'une carcasse (18) en matériau magnétique doux et deux pôles N et S comportant une association d'au moins deux types d'aimants permanents pour constituer la force magnétomotrice de la structure, se terminant par des pièces polaires en vis-à-vis (8) délimitant entre elles le volume donné d'entrefer (10) ouvert à l'extérieur, caractérisée en ce que les aimants (28, 30) des types précédents constituant les pôles sont empilés en série, parallèlement aux pièces polaires (8) entre celles-ci et la carcasse, leur induction ayant une direction perpendiculaire à ces mêmes pièces polaires.

2. Structure d'aimant permanent selon la revendication 1, caractérisée en ce que dans chaque pôle, les aimants sont au nombre de deux, séparés par une pièce polaire secondaire (32) de forme plane, leur section étant inversement proportionnelle à leur induction.

3. Structure d'aimant permanent selon les revendications 1 et 2, caractérisée en ce qu'elle comporte :
   - un aimant en ferrite (28) entre la carcasse magnétique et la pièce polaire secondaire,
   - un aimant en terre rare (30) entre la pièce polaire, secondaire (32) et la pièce polaire (8), la section offerte au flux magnétique par les aimants étant plus grande pour l'aimant en ferrite (28) que pour l'aimant en terre rare (30), dans un rapport sensiblement inversement proportionnel à leurs inductions.

4. Structure d'aimant permanent selon l'une quelconque des revendications 1 et 2 précédentes, caractérisée en ce que les sections des aimants et des pièces polaires (8) par des plans perpendiculaires à la direction de l'induction dans le volume de l'entrefer ont une forme géométrique choisie parmi les rectangles, les carrés et les cercles, la carcasse (18) étant alors composée d'un cylindre de matériau doux à base de forme choisie de façon correspondante selon les rectangles, les carrés et les cercles, dans lequel est ménagée l'ouverture nécessaire de l'entrefer (10) vers l'extérieur de la carcasse.

5. Structure d'aimant permanent selon la revendication 3, caractérisée en ce que la partie périphérique du volume d'entrefer (10) est remplie, entre les pièces polaires (8), par des premiers aimants (34) permanents en ferrite dur, d'aimantation parallèle et de sens opposé à celle des aimants de la structure.

6. Structure d'aimant selon la revendication 4, caractérisée en ce que les sections des aimants et des pièces polaires par des plans perpendiculaires à la direction de l'induction dans le volume de l'entrefer étant carrée ou rectangulaire, les premiers aimants permanents (34) en ferrite dur sont de forme parallèlépipédique, formant ainsi avec les pièces polaires un volume utile d'entrefer en forme de tunnel.

7. Structure d'aimant selon la revendication 4, caractérisée en ce que les sections des aimants et des pièces polaires par des plans perpendiculaires à la direction de l'induction dans le volume de l'entrefer étant circulaire, les premiers aimants permanents en ferrite (34) dur sont de forme torique à section rectangulaire, formant ainsi avec les pièces polaires un volume utile d'entrefer en forme de cylindre droit à base circulaire muni d'une fenêtre d'accès vers l'extérieur.

8. Structure d'aimant permanent selon les revendications 2 à 5 , caractérisée en ce que des seconds aimants permanents (36) en ferrite dur, d'aimantation perpendiculaire à la direction de l'induction dans le volume utile de l'entrefer, sont situés entre les bords des pièces polaires secondaires et la paroi en regard de la carcasse, ces aimants permanents ayant, par rapport au centre de la structure, une aimantation convergente pour les aimants (36) reliés à l'une des pièces polaires secondaires (32) et une aimantation divergente pour les aimants (36) reliés à l'autre des pièces polaires secondaires, le sens de ces aimantations étant choisi compatible avec celui des aimants des pôles N et S pour augmenter le flux dans l'entrefer.

9. Structure d'aimant permanent selon la revendication 8, caractérisée en ce que les seconds aimants permanents (36) sont disposés sur une partie seulement de la périphérie des pièces polaires secondaires.

10. Structure d'aimant permanent selon la revendication 8, caractérisée en ce que les seconds aimants permanents (36) sont disposés sur toute la périphérie des pièces polaires secondaires (32).

11. Structure d'aimant permanent selon la revendication 8, caractérisée en ce qu'elle comporte en outre des troisièmes aimants (38) en ferrite dur, d'aimantation perpendiculaire à la direction de l'induction dans le volume utile de l'entrefer, situés entre la périphérie des pièces polaires et la paroi en regard de la carcasse, ces aimants (38) ayant, par rapport au centre de la structure, une aimantation convergente pour les aimants (38) reliés à l'une des pièces polaires et une aimantation divergente pour les aimants (38) reliés à l'autre pièce polaire, le sens de ces aimants étant choisi compatible avec celui des aimants N et S pour augmenter le flux dans l'entrefer.

**12.** Structure selon la revendication 10, caractérisée en ce que les troisièmes aimants permanents (38) sont disposés sur une partie seulement de la périphérie des pièces polaires.

**13.** Structure selon la revendication 11, caractérisée en ce que les troisièmes aimants (38) permanents sont disposés sur toute la périphérie des pièces polaires.

FIG. 1

FIG. 2

FIG. 3

FIG. 4

FIG. 5

FIG. 6

EP 0 623 939 A1

Office européen
des brevets

**RAPPORT DE RECHERCHE EUROPEENNE**

Numero de la demande
EP 94 40 0929

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.5) |
|---|---|---|---|
| D,A | EP-A-0 262 880 (SUMIMOTO SPECIAL METAL) * abrégé; figures * | 1,3 | H01F7/02 G01R33/38 |
| A | US-A-4 707 663 (MINKOFF ET AL) * colonne 3, ligne 36 - ligne 56 * * colonne 4, ligne 29 - ligne 60; figures 1,2 * | 1,2 | |

**DOMAINES TECHNIQUES RECHERCHES (Int.Cl.5)**

H01F
G01R

Le présent rapport a été établi pour toutes les revendications

| Lieu de la recherche | Date d'achèvement de la recherche | Examinateur |
|---|---|---|
| LA HAYE | 9 Août 1994 | Marti Almeda, R |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

11